# EUROPEAN PATENT APPLICATION

(11) **EP 1 919 271 A2**
(43) Date of publication of application: **07.05.2008**
(21) Application number: 07114686.4
(22) Date of filing: 21.08.2007
(51) Int. Cl.: H05K 7/20

(54) **Air-conditioning installation and computer system**

(30) Priority: 30.10.2006 JP 2006294707
(71) Applicant: FUJITSU LIMITED, Kawasaki-shi, Kanagawa 211-8588 (JP)
(72) Inventor: Yamaoka, Nobuyoshi, Kawasaki-shi, Kanagawa 211-8588 (JP)
(74) Representative: Fenlon, Christine Lesley

(57) **Abstract**

An air conditioning installation cools computer apparatuses (111,112,113) by air-conditioning a room (10) where the computer apparatuses are installed. The air conditioning installation includes: (a) an inlet duct (21) for making air flow into the room; (b) an air-conditioner which sends air into the inlet duct, and (c) inlet fans (22a,22b,22c) for the respective computer apparatuses to be cooled. The inlet fans (22a,22b,22c) are disposed at positions corresponding to inlets (111a,112a,113a) of the computer apparatuses (111,112,113) installed in the room (10), and send air flown through the inlet duct (21) into the room (20) such that the air flows toward the inlets (111a,112a,113a) of the computer apparatuses (111,112,113).

## Description

### BACKGROUND OF THE INVENTION

### 1. Field of the Invention

The present invention relates to an air conditioning installation which air-conditions a room where computer apparatuses for data processing are installed in order to cool the computer apparatuses, and a computer system which has computer apparatuses and an air-conditioning installation.

### 2. Description of the Related Art

Conventionally, there has been employed a method in which a room where plural large computer apparatuses, for example, servers and storages are installed is air-conditioned so as to cool these computer apparatuses.

When an air conditioning installation for the computer room is designed, air-conditioning ability is estimated based on a total heating value of the computer apparatuses installed in the computer room. Then, an amount of cool air required for necessary air-conditioning ability is blown directly into the computer room or is blown into a space under a free access floor for cable wiring or the like which is disposed under a floor of the computer room.

But in the case of a direct blow into the computer room, a stream of cool air from one computer apparatus is sometimes prevented from flowing smoothly due to existence of another computer apparatus which is located downstream. Also, a stream of cool air is sometimes prevented from flowing smoothly because in the computer room there are ordinarily various apparatuses and installations besides computer apparatuses to be cooled. As a result, in the case of a direct blow into the computer room, it is sometimes impossible for the air conditioning installation to show its air-conditioning ability as designed and carry out necessary cooling because of difficulty in even air-conditioning of the whole room and large differences in the temperature depending on locations in the computer room.

Also, in the case of a blow into a space under a free access floor, it is sometimes impossible for the air conditioning installation to show its air-conditioning ability as designed because many cables ordinarily disposed in the space prevent smooth flowing of a stream of cool air.

It seems practicable to design an air conditioning installation which shows enough air-conditioning ability even if there are obstacles, on supposition that there exist obstacles which prevent a stream of cool air from flowing smoothly. But in this case, higher driving cost for the air conditioning installation is required in addition to significantly increased power consumption. Therefore, this choice is disadvantageous in terms of lower power consumption and driving cost.

Moreover, each of computer apparatuses has generally a different heating value, and it is impossible to control cooling ability of the above-described air conditioning installation for the respective computer apparatuses.

Japanese Patent Application Publication No. 2002-61911 discloses an air conditioning installation which has a structure in which air-conditioned cool air from an air-conditioner is blown into a computer room via a duct under a floor of the computer room. In the air-conditioning installation, air-conditioned cool air is smoothly blown into a computer room because there is installed a duct under a floor of the computer room, but it is impossible to individually control its cooling ability for each computer apparatus.

Japanese Patent Application Publication No. 2002-6992 discloses an air conditioning installation which has a structure in which air-conditioned cool air is blown into a computer room by a fan from a space under a floor of the computer room. In the air-conditioning installation, it is possible to always keep airflow in a computer room constant by controlling a rotational velocity of the fan even if an amount of cool air from a space under the floor changes. But, in the case in which there are several computer apparatuses in the computer room, it is impossible to individually control its cooling ability for each computer apparatus.

Japanese Patent Application Publication No. 2005-503529 discloses a control method to control a flow of air in a rack. But Japanese Patent Application Publication No. 2005-503529 does not disclose air-conditioning a whole of a computer room.

### SUMMARY OF THE INVENTION

Accordingly, it is desirable to provide an air conditioning installation which is driven with lower power consumption and cools enough each computer apparatus, and a computer system including the computer apparatuses and the air-conditioning installation.

According to a first aspect of the present invention there is provided an air conditioning installation which cools computer apparatuses for data processing by air-conditioning a room where the computer apparatuses are installed, the air conditioning installation including:
(a) an inlet duct for making air flow into the room;
(b) an air-conditioner which sends air into the inlet duct; and
(c) inlet fans, for the respective computer apparatuses to be cooled, which are disposed at positions corresponding to inlets of the computer apparatuses installed in the room and which send air flown through the inlet duct into the room such that the air flows toward the inlets of the computer apparatuses.

According to an embodiment of the present invention, the air conditioning installation has the inlet duct and can let a stream of air-conditioned cool air flow smoothly. In addition, there are disposed the inlet fans for the respective computer apparatuses at the positions corresponding to the inlets of the computer apparatuses. Thus, the air conditioning installation can cool each of computer apparatuses sufficiently.

Also, according to an embodiment of the present invention, even if there are apparatuses and installations in the computer room other than the ones to be cooled, their existence does not obstruct cooling of the computer apparatuses significantly.

Preferably, an air conditioning installation embodying the present invention further comprising:
(a) an outlet duct for making air flow out of the room; and
(b) outlet fans, for the respective computer apparatuses to be cooled, which are disposed at positions corresponding to outlets of the computer apparatuses installed in the room, and which send air, that is exhausted from the outlets of the computer apparatuses to the room, into the outlet duct.

In this case, further reduction in power consumption and more precise control for individual cooling of the computer apparatuses can be realized because a stream of the exhausted air is also controlled for each of the computer apparatuses.

In an air conditioning installation embodying the present invention, preferably the inlet duct is disposed near a floor of the room.

Thus, it is possible to use a rising stream of air which is induced by temperature increase.

In an air conditioning installation embodying the present invention, preferably the inlet duct is disposed near a floor of the room, and more preferably an upper surface of the inlet duct is formed by a combination of unit panels.

The above features make it possible to dispose the inlet fans at the desired position by combining the unit panels. As a result, options as to where the computer apparatuses are disposed in the room increase.

In an air conditioning installation embodying the present invention, preferably the outlet duct is disposed near a ceiling of the room. In this case, preferably a lower surface of the outlet duct is formed by a combination of unit panels. Moreover, acceptably the ceiling is formed by the combination of unit panels.

It is possible to use a rising stream of air which is induced by temperature increase by disposing the outlet duct near the ceiling. Moreover, it is also possible to dispose the outlet fans at the desired position by combining the unit panels. As a result, options for disposing the computer apparatuses in the room increase.

In an air conditioning installation embodying the present invention, preferably at least one of the inlet fan and the outlet fan is a rotation-changeable fan whose rotational speed is changeable according to a control signal, the air conditioning installation further including:
(a) outlet temperature sensors disposed respectively corresponding to the outlet fans which measure temperature of air exhausted from the respective computer apparatuses corresponding to the outlet fans; and
(b) a fan controller which individually controls rotational speed of the rotation-changeable fan based on the temperature measurement result by the outlet temperature sensors.

In this case, more preferably the air conditioning installation further includes inlet temperature sensors disposed respectively corresponding to the inlet fans which measure temperature of air taken in the respective computer apparatuses corresponding to the inlet fans,
wherein the fan controller controls the rotational speed of the rotation-changeable fan based on the temperature measurement result by the inlet temperature sensors in addition to the temperature measurement result by the outlet temperature sensors.

Even in the case where only a single computer apparatus is installed, heating value changes with time depending on how the computer apparatus is driven. If the structure is employed in which a rotational speed of each fan is individually controlled based on the temperature measurement result by the temperature sensors for the outlet fans or both the outlet fans and the inlet fans, it is possible to individually optimize a flow of cool air flowing through each computer apparatus with time according to each heating value of the computer apparatuses which changes with time. Therefore, more preferable air conditioning installation is realized in terms of lower power consumption and driving cost.

Additionally, a computer system according to a second aspect of the present invention has computer apparatuses installed in a room for data processing including numerical calculation, and an air conditioning installation which cools the computer apparatuses by air-conditioning the room, wherein the air conditioning installation including:
(a) an inlet duct for making air flow into the room;
(b) an air-conditioner which sends air into the inlet duct; and
(c) inlet fans, for the respective computer apparatuses to be cooled, which are disposed at positions corresponding to inlets of the computer apparatuses installed in the room, and which send air flown through the inlet duct into the room such that the air flows toward the inlets of the computer apparatuses.

In a computer system embodying the present invention, preferably the air conditioning installation further includes:
(a) an outlet duct for making air flow out of the room; and
(b) outlet fans, for the respective computer apparatuses to be cooled, which are disposed at positions corresponding to outlets of the computer apparatuses installed in the room, and which send air, that is exhausted from the outlets of the computer apparatuses to the room, into the outlet duct.

A computer system embodying the invention includes features corresponding to all the above mentioned features of the air conditioning installation according to the invention.

As described above, an embodiment of the present invention can realize lower power consumption and perform sufficient cooling for each computer apparatus.

### BRIEF DESCRIPTION OF THE DRAWINGS

Embodiment(s) of the present invention will be described below with reference to the attached drawings.
Fig. 1 is a schematic diagram showing a computer room where computer apparatuses are installed, and an air conditioning installation which air-conditions the computer room;
Fig. 2A is a lateral view which shows an example of an outlet duct;
Fig, 2B is a lower-side view of the example of Fig. 2A;
Fig. 3 shows a control system of the air-conditioning installation;

### DETAILED DESCRIPTION OF THE INVENTION

Embodiment(s) of the present invention will be described below.

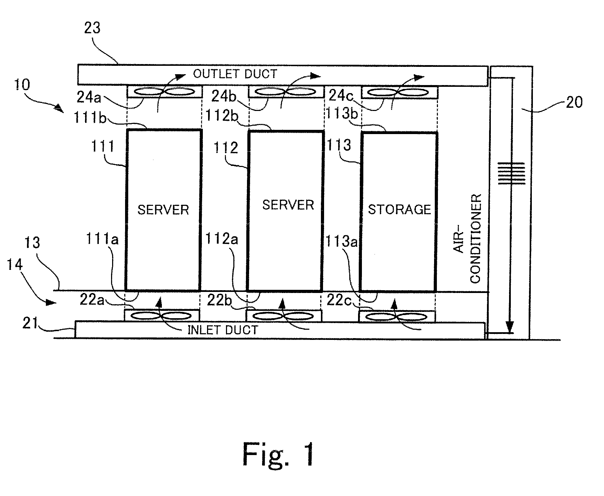

Fig. 1 is a schematic diagram showing a computer room where computer apparatuses are installed, and an air conditioning installation which air-conditions the computer room.

In a computer room 10 shown in Fig. 1, there are disposed servers 111, 112 and storage 113 each of which is a kind of large computer.

Also, there is respectively provided an inlet duct 21 near a floor of the computer room 10 through which air is sent from an air-conditioner 20. In addition, inlet fans 22a, 22b, 22c are disposed on the inlet duct 21 at the respective positions corresponding to the servers 111, 112 and the storage 113 which are subjects to be cooled.

The upper surface of the inlet duct 21 is made of a combination of unit panels. Therefore, it is possible to dispose the inlet fans at desired positions by combining the unit panels. As a result, options as to where the computer apparatuses are disposed in the room increase.

An outlet duct 23 which will be described later also has a combination of unit panels of the same structure as that of the inlet duct 21. The structure of the combination of unit panels will be described later in detail when the outlet duct 23 is described as an example.

The floor surface of the computer room 10 on which the servers 111, 112 and the storage 113 are disposed is made of a free access floor surface 13. The free access floor surface 13 has a structure that unit panels are laid over the whole of the floor surface 13. Each of the unit panels has a hole to secure an air flow. Air-conditioned cool air which comes through the inlet duct 21 and is blown up by the inlet fans 22a, 22b, 22c goes through holes of the unit panels and flows into the servers 111, 112 and the storage 113 through inlets 111a, 112a, 113a which are disposed on the lower surfaces of the servers 111, 112 and the storage 113 respectively.

Fans (not shown) for taking in air at the inlets 111a, 112a, 113a are also disposed on the lower surfaces of the servers 111, 112 and the storage 113. These fans increase efficiency to take in air-conditioned cool air for the servers 111, 112 and the storage 113.

There is a space 14 between the inlet duct 21 and the free access floor surface 13, where a number of cables (not shown) or the like are laid such that they do not cover the upper surfaces of the inlet fans 22a, 22b, 22c.

The air which is taken into the servers 111, 112 and the storage 113 gets warm to the extent depending on how the servers 111, 112 and the storage 113 are driven. Then the air flows in the computer room 10 through the outlets 111b, 112b, 113b which are disposed on the upper surfaces of the servers 111, 112 and the storage 113 respectively. In the servers 111, 112 and the storage 113, there are also respectively provided fans (not shown) at the outlets 111b, 112b, 113b, and these fans efficiently exhaust the air into the computer room 10.

There is provided the outlet duct 23 near a ceiling of the computer room 10. In addition, there are provided outlet fans 24a, 24b, 24c which send the exhaust air in the computer room 10 into the outlet duct 23. The outlet fans 24a, 24b, 24c are provided at the positions on the outlet duct 23 corresponding to the outlets 111b, 112b, 113b of the servers 111, 112 and the storage 113 respectively. The air sent into the outlet duct 23 comes back to the air-conditioner 20 through the outlet duct 23.

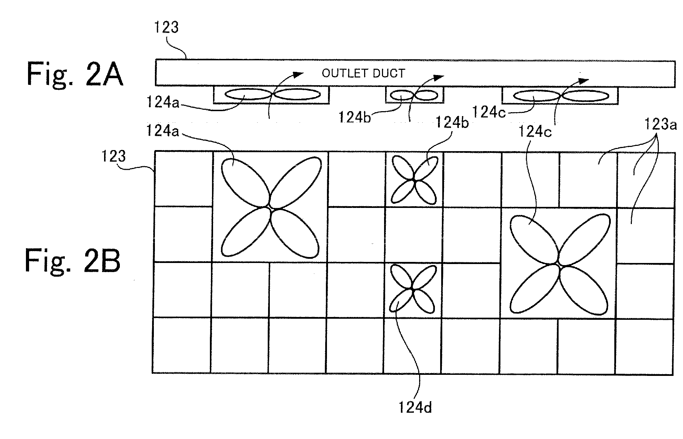

Fig. 2A is a lateral view which shows an example of an outlet duct, and Fig, 2B is a lower-surface view of the example. Fig. 2A and Fig. 2B show an outlet duct 123 which has a different shape from that of the outlet duct 23 shown in Fig. 1.

Here, the outlet duct 123 has four outlet fans 124a, 124b, 124c, 124d as shown in Fig. 2B.

The outlet duct 123 has a structure in which plural unit panels, for example, each in a rectangle shape of about 500 mm side length, are combined. The respective sizes of the outlet fans 124a, 124b, 124c, 124d are determined by the number of unit panels 123a. Therefore, it is possible to dispose the outlet fans 124a, 124b, 124c, 124d at desired positions by combining unit panels.

The description of the outlet duct has been made as an example, but the inlet duct (as shown in Fig. 1) also has the same structure as that of the outlet duct.

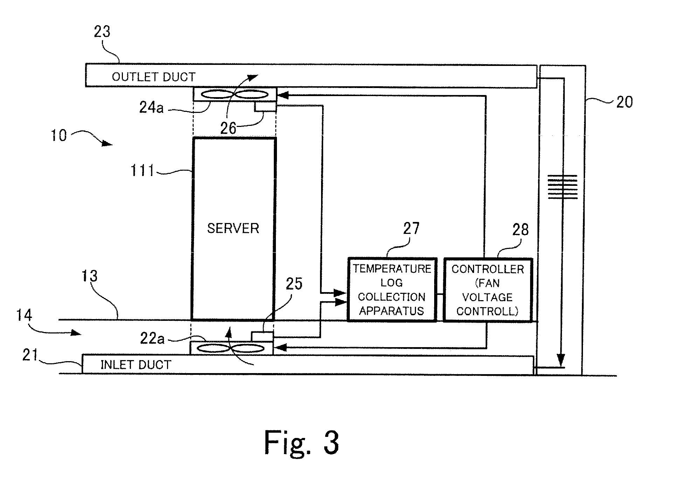

Fig. 3 shows a control system of the air-conditioning installation. The server 111 of the three computer apparatuses (the servers 111, 112 and the storage 113) in Fig. 1 represents the three computer apparatuses.

Both the inlet fan 22a and the outlet fan 24a are rotation-changeable fans whose rotational speed can be changed according to a control voltage. These inlet fan 22a and the outlet fan 24a are disposed right just above and below the server 111 respectively (see Fig. 1), corresponding to the server 111.

There are provided an inlet temperature sensor 25 and an outlet temperature sensor 26 respectively at the entrance of air where the inlet fan 22a is located and at the exit of air where the outlet fan 24a is located. The inlet temperature sensor 25 measures the temperature of air flown from the inlet fan 22a and the outlet temperature sensor 26 measures the temperature of air flown toward the outlet fan 24a.

The temperature measurement results by the inlet temperature sensor 25 and outlet temperature sensor 26 are input into a temperature log collection apparatus 27 and the temperature change is recorded.

The temperature measurement results are also sent to the controller 28. Based on the temperature measurement results, the controller 28 outputs a control voltage toward the inlet fan 22a and the outlet fan 24a. The inlet fan 22a and the outlet fan 24a rotate at a rotational speed according to the control voltage, by which airflow is adjusted.

Fig. 3 shows only the server 111, but actually there are the inlet temperature sensor 25 and outlet temperature sensor 26 respectively disposed at the entrance of air where each inlet fan is located and at the exit of air where each outlet fan is located. Rotational speeds of the inlet fan and the outlet fan are individually controlled with respect to each of the computer apparatuses (the servers 111, 112 and the storage 113 in Fig. 1, for example) which are installed in the computer room 20 and are subjects to be cooled.

As shown in Fig. 3, there are preferably provided the inlet temperature sensor 25 and the outlet temperature sensor 26 corresponding to the inlet fan 22a and the outlet fan 24a respectively. But it is also possible to control airflow of each computer apparatus individually even in the case in which there is only provided the outlet temperature sensor 26 without the inlet temperature sensor 25.

Additionally, in Fig. 3, although both the inlet fan 22a and the outlet fan 24a are rotation-changeable fans as described above, either of the inlet fan 22a or the outlet fan 24a may be a rotation-changeable fan.

## Claims

1. An air conditioning installation which cools computer apparatuses for data processing by air-conditioning a room where the computer apparatuses are installed, the air conditioning installation comprising:
(a) an inlet duct for making air flow into the room;
(b) an air-conditioner which sends air into the inlet duct; and
(c) inlet fans, for the respective computer apparatuses to be cooled, which are disposed at positions corresponding to inlets of the computer apparatuses installed in the room and which send air flown through the inlet duct into the room such that the air flows toward the inlets of the computer apparatuses.

2. The air conditioning installation according to claim 1 further comprising:
(a) an outlet duct for making air flow out of the room; and
(b) outlet fans, for the respective computer apparatuses to be cooled, which are disposed at positions corresponding to outlets of the computer apparatuses installed in the room, and which send air, that is exhausted from the outlets of the computer apparatuses to the room, into the outlet duct.

3. The air conditioning installation according to claim 1 or 2, wherein the inlet duct is disposed near a floor of the room.

4. The air conditioning installation according to claim 3, wherein an upper surface of the inlet duct is formed by a combination, of unit panels.

5. The air conditioning installation according to any one of claims 2 to 4, wherein the outlet duct is disposed near a ceiling of the room.

6. The air conditioning installation according to claim 5, wherein a lower surface of the outlet duct is formed by a combination of unit panels.

7. The air conditioning installation according to any one of claims 2 to 6, wherein at least one of the inlet fan and the outlet fan is a rotation-changeable fan whose rotational speed is changeable according to a control signal, the air conditioning installation further comprising:
(a) outlet temperature sensors disposed respectively corresponding to the outlet fans which measure temperature of air exhausted from the respective computer apparatuses corresponding to the outlet fans; and
(b) a fan controller which individually controls rotational speed of the rotation-changeable fan based on the temperature measurement result by the outlet temperature sensors.

8. The air conditioning installation according to claim 7 further comprising inlet temperature sensors disposed respectively corresponding to the inlet fans which measure temperature of air taken in the respective computer apparatuses corresponding to the inlet fans,
wherein the fan controller controls the rotational speed of the rotation-changeable fan based on the temperature measurement result by the inlet temperature sensors in addition to the temperature measurement result by the outlet temperature sensors.

9. A computer system which has computer apparatuses installed in a room for data processing including numerical calculation, and an air conditioning installation which cools the computer apparatuses by air-conditioning the room, wherein the air conditioning installation comprising:
(a) an inlet duct for making air flow into the room;
(b) an air-conditioner which sends air into the inlet duct; and
(c) inlet fans, for the respective computer apparatuses to be cooled, which are disposed at positions corresponding to inlets of the computer apparatuses installed in the room, and which send air flown through the inlet duct into the room such that the air flows toward the inlets of the computer apparatuses.

10. The computer system according to claim 9, wherein the air conditioning installation further comprising:
(a) an outlet duct for making air flow out of the room; and
(b) outlet fans, for the respective computer apparatuses to be cooled, which are disposed at positions corresponding to outlets of the computer apparatuses installed in the room, and which send air, that is exhausted from the outlets of the computer apparatuses to the room, into the outlet duct.
